# EUROPÄISCHE PATENTANMELDUNG

(11) **EP 3 460 092 A1**
(43) Veröffentlichungstag der Anmeldung: **27.03.2019**
(21) Anmeldenummer: 18194963.7
(22) Anmeldetag: 17.09.2018
(51) Int. Cl.: C23C 14/24, C23C 14/14, G02B 1/113, B60R 13/08, C23C 14/56, C23C 14/16

(54) **NIEDRIGEMISSIONSBESCHICHTUNG**

(30) Priorität: 21.09.2017 DE 102017121957
(71) Anmelder: Siefert, Wolfgang, 77955 Ettenheim (DE); Müller, Roland, 79336 Herbolzheim (DE)
(72) Erfinder: Siefert, Wolfgang, 77955 Ettenheim (DE); Müller, Roland, 79336 Herbolzheim (DE)
(74) Vertreter: Straube, Urs Norman

(57) **Zusammenfassung**

Die vorliegende Erfindung betrifft eine Niedrigemissionsbeschichtung (16, 18). Damit die Niedrigemissionsbeschichtung (16, 18) besonders kostengünstig herstellbar ist, besteht die Niedrigemissionsbeschichtung (16, 18) im Wesentlichen aus Zinn.

## Beschreibung

Die vorliegende Erfindung betrifft eine Niedrigemissionsbeschichtung gemäß dem Oberbegriff des Patentanspruchs 1, ein Verfahren zur Herstellung der Niedrigemissionsbeschichtung gemäß dem Oberbegriff des Patentanspruchs 6, ein Flächenelement mit der Niedrigemissionsbeschichtung gemäß dem Oberbegriff des Patentanspruchs 13, und ein Verkleidungsteil mit der Niedrigemissionsbeschichtung gemäß dem Oberbegriff des Patentanspruchs 15.

Niedrigemissionsbeschichtungen (Low-E-Beschichtungen) zeichnen sich durch einen niedrigen Emissionsgrad im Infrarotbereich aus und werden daher zur Isolierung verwendet. Im Zusammenhang mit der vorliegenden Erfindung handelt es sich bei Niedrigemissionsbeschichtungen um Beschichtungen, welche die Emission von mit diesen beschichteten Körpern im Infrarotbereich verringern und deren Emissionsgrad insbesondere im Wellenlängenbereich von 1 µm bis 40 µm vorzugsweise unter 0,5, noch bevorzugter unter 0,3, liegt. Neben einem geringen Emissionsgrad im Infrarotbereich sollten die Werkstoffe, aus denen die Niedrigemissionsbeschichtungen bestehen, eine hohe Beständigkeit, insbesondere eine hohe Korrosionsstabilität, hohe Verfügbarkeit und eine gute Verarbeitbarkeit aufweisen. Die Verarbeitbarkeit und Verfügbarkeit sind gleichermaßen für die Herstellungskosten der Beschichtung verantwortlich, so dass eine gute Verarbeitbarkeit eine geringe Verfügbarkeit in der Regel zumindest teilweise ausgleichen kann und umgekehrt. Typische Niedrigemissionsbeschichtungen bestehen aus Zinn-, Zink- oder Titanoxiden, Siliziumnitrid, Zinksulfid und Nickelchromlegierungen, Silber, Kupfer, Gold oder Aluminium, wobei der Anteil von Aluminium an den Niedrigemissionsbeschichtungen schätzungsweise über 95 % ausmacht. Lediglich der Anteil von Kupfer liegt noch im nennenswerten Bereich von einigen Prozent, während Niedrigemissionsbeschichtungen aus sämtlichen anderen aufgeführten Werkstoffen exotisch sind.

Niedrigemissionsbeschichtungen werden bevorzugt durch ein Verfahren der physikalischen Gasphasenabscheidung (physical vapor deposition, PVD) hergestellt. PVD-Verfahren zeichnen sich durch eine Reihe von Vorteilen aus, von denen besonders die Möglichkeit der Beschichtung mit vielen gewünschten Werkstoffen, die Reproduzierbarkeit der Schichteigenschaften, die gezielte Einstellung gewünschter Schichteigenschaften und die große Schichtreinheit hervorzuheben sind. Bei PVD-Verfahren handelt es sich um vakuumbasierte Beschichtungsverfahren, bei denen mit Hilfe physikalischer Prozesse das Beschichtungsmaterial in die Gasphase überführt wird und anschließend als dünne Schicht auf einem Substrat kondensiert. Für den industriellen Einsatz sind unter den PVD-Verfahren insbesondere das thermische Verdampfen und die Kathodenzerstäubung (Sputtern) von großer Bedeutung.

Beim thermischen Verdampfen in einem Roll Coater, der für das Beschichten von Substraten in Form von großflächigen, flexiblen Substratbahnen ideal ist, wird das Beschichtungsmaterial typischerweise in Form von Beschichtungsmaterialdrähten kontinuierlich auf widerstandsbeheizte Tiegel zugeführt. Die Beschichtungsmaterialdrähte verflüssigen sich zunächst und gehen dann in Form einer Dampfwolke in die Gasphase über. Die zu beschichtende Substratbahn wird über eine rotierende, gekühlte Beschichtungswalze geführt, die knapp über den Tiegeln positioniert ist. Somit dampft das Beschichtungsmaterial auf das Substrat auf, wo es dann kondensiert und die gewünschte Beschichtungsschicht bildet. Über die Geschwindigkeit (Vorschubgeschwindigkeit des Beschichtungsmaterialdrahtes), mit welcher der Beschichtungsmaterialdraht zugeführt wird, und die Temperatur der Tiegel lässt sich die verdampfte Menge des Beschichtungsmaterials und in Verbindung mit der Geschwindigkeit (Vorschubgeschwindigkeit der Substratbahn), mit welcher die Substratbahn über die Beschichtungswalze läuft, die gewünschte Schichtdicke einstellen.

In der Praxis ist das Magnetronsputtern das wirtschaftlichste Verfahren der Kathodenzerstäubung. Bei diesem Verfahren wird das Beschichtungsmaterial in Form von Platten (Targets) eingesetzt. Zwischen dem Target und dem Substrat wird ein elektrisches Feld erzeugt, wobei das Target auf negatives Potenzial gelegt ist. Innerhalb des elektrischen Feldes wird ein Plasma aus positiven Argonionen, Elektronen und Neutralteilchen erzeugt. Die Argonionen werden im elektrischen Feld durch das negative Target beschleunigt und angezogen, hierbei kommt es zu Stoßprozessen, bei denen die Targetatome abgetragen bzw. zerstäubt (engl.: sputtern) werden. Der dadurch erzeugte Metalldampf kondensiert als dünne Schicht auf dem vorbei geführten Substrat. Durch unter den Targets angebrachte Magnete wird die Ionisationsrate und damit die Abscheiderate deutlich erhöht. Die Kathodenzerstäubung bietet gegenüber dem thermischen Verdampfen Vorteile hinsichtlich einer größeren Auswahl an Beschichtungsmaterialien, einer besseren Haftung des Beschichtungsmaterials auf dem Substrat und einer gleichmäßigeren Schichtdickenverteilung. Der Nachteil der Kathodenzerstäubung ist, dass aufgrund einer wesentlich niedrigeren Abscheidungsrate langsamere Vorschubgeschwindigkeiten der Substratbahn verwendet werden müssen, um gleiche Schichtdicken wie beim thermischen Verdampfen zu erhalten, was gegenüber dem thermischen Verdampfen zu erhöhten Herstellungskosten führt.

Verkleidungsteile mit Niedrigemissionsbeschichtungen zur thermischen Isolierung finden insbesondere im Fahrzeugbau Anwendung, wie es in den Patentanmeldungen DE 10 2010 051 612 A1, DE 10 2011 118 420 A1 und DE 10 2013 016 495 A1 und der Gebrauchsmusteranmeldung DE 20 2010 017 432 offenbart ist.

Der vorliegenden Erfindung liegt die Aufgabe zugrunde, eine Niedrigemissionsbeschichtung, ein Verfahren zur Herstellung der Niedrigemissionsbeschichtung ein Flächenelement mit der Niedrigemissionsbeschichtung, und ein Verkleidungsteil mit der Niedrigemissionsbeschichtung zu schaffen, die besonders kostengünstig sind.

Die der Erfindung zugrunde liegende Aufgabe wird durch eine Niedrigemissionsbeschichtung gelöst, wobei die Niedrigemissionsbeschichtung im Wesentlichen aus Zinn besteht. Im Zusammenhang mit der Erfindung bedeutet "im Wesentlichen aus Zinn" aus mindestens 60 Gew.-% (Gewichtsprozent) Zinn, vorzugsweise mindestens 80 Gew.-% Zinn, noch bevorzugter mindestens 90 Gew.-% Zinn. Die Dicke der Beschichtung ist vorzugsweise im Wesentlichen konstant und beträgt vorzugsweise zwischen 20 nm und 200 nm, noch bevorzugter zwischen 50 nm und 100 nm. "Im Wesentlichen konstant" bedeutet im Zusammenhang mit der vorliegenden Erfindung, dass die Dicke der Schicht in einem Intervall d ± Δ in einem relevanten flächigen Bereich liegt, wobei d die gewünschte oder mittlere (durchschnittlichen) Schichtdicke ist und Δ die maximale, gewünschte Abweichung ist. Δ ist vorzugsweise kleiner als 0,5 d, noch bevorzugter kleiner als 0,3 d, besonders bevorzugt kleiner als 0,2 d. Für Δ = 0,2 und eine gewünschte Schichtdicke von 20 nm ist die Schichtdicke also im Wesentlichen konstant, wenn diese in dem relevanten flächigen Bereich zwischen 16 und 24 nm liegt. Für Δ = 0,2 und eine gewünschte Schichtdicke von 200 nm ist die Schichtdicke also im Wesentlichen konstant, wenn diese in dem relevanten flächigen Bereich zwischen 160 und 240 nm liegt. Im Zusammenhang mit der vorliegenden Erfindung kann der relevante flächige Bereich ein Bereich der beschichteten Substratbahn sein, der in einem Produkt wie einem Verkleidungsteil verwendet werden soll. Der relevante flächige Bereich kann aus einem Abschnitt einer beschichteten Substratbahn oder eines beschichteten Substrats von mehreren Metern Länge (mindestens 3 m, vorzugsweise mindestens 5 m, noch bevorzugter mindestens 10 m, besonders bevorzugt mindestens 50 m oder 100 m) bestehen, der vorzugsweise über fast die gesamte Breite der Substratbahn abgesehen von jeweils einem schmalen Randbereich an den beiden gegenüberliegenden Rändern der Substratbahn in Längsrichtung mit einer Breite von weniger als 20 cm, vorzugsweise weniger als 10 cm, verläuft. Vorzugsweise besteht der relevante flächige Bereich aus einem Abschnitt einer beschichteten Substratbahn oder eines beschichteten Substrats mit einer Fläche von mindestens 1 m², vorzugsweise mindestens 5 m², noch bevorzugter mindest 10 m², besonders bevorzugt mindestens 50 m² oder 100 m². Vorzugsweise ist der relevante flächige Bereich zusammenhängend und umschließt keine anderen Bereiche auf der beschichteten Substratbahn oder dem beschichteten Substrat, die nicht zu dem relevanten flächigen Bereich gehören. Vorzugsweise hat der relevante flächige Bereich eine Breite von mindestens 50 cm, vorzugsweise mindestens 1 m, besonders bevorzugt mindestens 1,3 m. Bei der Substratbahn oder dem Substrat handelt es sich vorzugsweise um ein flächiges, flexibles Gebilde, insbesondere ein Vlies, ein Gewebe oder eine Folie.

Obwohl Zinn einen geringen Emissionsgrad im Infrarotbereich, eine hohe Beständigkeit zumindest als Bestandteil einer Legierung, eine hohe Verfügbarkeit, die sich wirtschaftlich in einem geringen Preis widerspiegelt, aufweist, wurde es bisher zumindest als Material für Niedrigemissionsbeschichtungen in Form von Verdampfungsbeschichtungen nicht berücksichtigt. Die Verwendung von Zinn in Form von Verdampfungsbeschichtungen stellt also eine Abkehr von technisch Üblichem dar. Offensichtlich besteht in der Fachwelt eine ablehnende Haltung hinsichtlich der Verwendung von Zinn in Form von Verdampfungsbeschichtungen. Damit Zinn für die Niedrigemissionsbeschichtungen verwendbar ist, wäre ferner eine gute Verarbeitbarkeit erforderlich. Hinsichtlich der Verarbeitbarkeit von Zinn für Niedrigemissionsschichten in Form von Verdampfungsbeschichtungen gibt es bisher keine relevanten Erkenntnisse. Bestehende Herstellungsanlagen sind zudem vor allem für die herkömmlichen Niedrigemissionsbeschichtungen aus Aluminium und Kupfer ausgelegt.

Die Erfinder untersuchten zunächst Verfahren zur Herstellung von Niedrigemissionsbeschichtungen in einem Roll Coater durch thermischen Verdampfen unter Verwendung von üblichen Einstellungsparametern (im Bereich von denjenigen für Aluminium und Kupfer) insbesondere für die Temperatur des Tiegels, die Vorlaufgeschwindigkeit der Substratbahn und die Vorlaufgeschwindigkeit des Beschichtungsmaterialdrahts. Das Ergebnis der Verfahren sind Substratbahnen mit Beschichtungen, wobei die Dicke der Beschichtung stark schwankt, und wobei Löcher durch die Beschichtungen und Substratbahnen hindurchgehen. Diese so erhaltenen Substratbahnen sind daher nicht verwertbar. Somit wurde es den Erfindern klar, dass die Herstellung von Niedrigemissionsbeschichtungen im Wesentlichen aus Zinn, wenn sie überhaupt möglich sein sollte, zumindest Anpassungen des üblichen Herstellungsverfahrens erfordern würde.

Nach längeren Untersuchungen kamen die Erfinder schließlich zu dem Schluss, dass die Ursache für die Defekte der erhaltenen Substratbahnen mit dem relativ niedrigen Schmelzpunkt von Zinn zusammenhängen. Im Vergleich zu den herkömmlichsten Materialien für Niedrigemissionsbeschichtungen, nämlich Aluminium (Schmelzpunkt: 660,2 °C; Siedepunkt: 2470 °C) und Kupfer (Schmelzpunkt: 1084,62 °C; Siedepunkt: 2595 °C), weist Zinn einen Schmelzpunkt von 231,93 °C und einen Siedepunkt von 2620 °C auf. Wenn das Beschichtungsmaterial Zinn in einem Roll Coater in Form von Beschichtungsmaterialdrähten zu mehreren Tiegeln zugeführt wird, schmilzt der Beschichtungsmaterialdraht bei üblichen Einstellungsparametern des Roll Coaters in einem relativ großen Abstand von der Oberfläche des Tiegels. Das geschmolzene Beschichtungsmaterial tropft dann in einem relativ großen Abstand auf die Oberfläche des Tiegels und es entstehen Spritzer, wobei das Beschichtungsmaterial zu den Tiegeln in unkontrollierten Mengen zugeführt wird. Die Verdampfungstemperatur des Tiegels lässt sich für Zinn jedoch aufgrund des relativ hohen Dampfdrucks von Zinn nicht wesentlich absenken.

Um diese Probleme abzustellen, entwickelten die Erfinder mehrere Lösungsansätze. Eine Lösung besteht darin, das Beschichtungsmaterial in flüssiger Form über eine Leitung oder einen Kanal zu der Oberfläche des Tiegels zuzuführen. Eine andere Lösung besteht darin, das frühzeitige Tropfen des geschmolzenen Beschichtungsmaterials durch eine Antitropfvorrichtung zu verhindern. Diese Lösung wird weiter unten im Detail beschrieben werden. Eine weitere Lösung besteht darin, ein sehr feines Pulver zu der Oberfläche des Schmelztiegels gezielt zuzuführen. Noch eine weitere Lösung besteht darin, eine hohe Vorschubgeschwindigkeit des Materialdrahts zu wählen. Diese Lösung kann mit einer Antitropfvorrichtung kombiniert werden. Als wichtig erwies sich auch die Auswahl eines Tiegels aus einem Material, welches eine gute Benetzbarkeit für Zinn aufweist. Vorteilhafterweise erfordern sämtliche dieser Lösungsansätze nur geringe Modifikationen bekannter Herstellungsanlagen und/oder -verfahren. Unter der Verwendung einer modifizierten Herstellungsanlagen und/oder eines modifizierten Herstellungsverfahrens ist es den Erfindern erstmals gelungen, Niedrigemissionsbeschichtungen in Form von Verdampfungsbeschichtungen aus Zinn herzustellen, wobei die Niedrigemissionsbeschichtungen sogar für industrielle Anwendungen eine ausreichende Reproduzierbarkeit und Uniformität aufweisen.

In einer bevorzugten Ausführungsform weist die Niedrigemissionsbeschichtung mindestens 95 Gew.-% Zinn auf. Reines Zinn ist anfällig für die sogenannte Zinnpest, die auf einer Umwandlung von β-Zinn zu α-Zinn unterhalb von 13,2 °C beruht. Für manche Anwendungen kann reines Zinn, also 100 Gew.-% Zinn, verwendet werden. Für andere Anwendungen, für welche die Beschichtung einer weitaus größeren Kälte ausgesetzt ist, wird die Zinnpest durch das Hinzufügen von weiteren Bestandteilen vermieden.

In noch einer bevorzugten Ausführungsform besteht die Niedrigemissionsbeschichtung aus einer Zinnlegierung, die ferner Bismut, Silber und/oder Antimon umfasst. Diese Legierungsbestandteile können die Zinnpest verhindern.

In einer Weiterbildung der letztgenannten bevorzugten Ausführungsform liegt der Anteil von Bismut, Silber und/oder Antimon zwischen 0,01 und 5 Gew.-%, vorzugsweise zwischen 0,05 und 2 Gew.-%, noch bevorzugter zwischen 0,1 und 1,5 Gew.-%. Wie experimentell verifiziert wurde, reichen derartige Konzentrationen der obigen Legierungsbestandteile aus, um die Zinnpest unter natürlichen Bedingungen auszuschließen.

In noch einer bevorzugten Ausführungsform ist die Niedrigemissionsbeschichtung eine Vakuumbeschichtung, vorzugsweise eine Verdampfungsbeschichtung. Im Zusammenhang mit der vorliegenden Erfindung ist eine Vakuumbeschichtung eine Beschichtung, die durch Vakuumverfahren wie thermisches Verdampfen oder Sputtern erzeugt wurde. Im Zusammenhang mit der vorliegenden Erfindung ist eine Verdampfungsbeschichtung eine Beschichtung, die durch thermisches Verdampfen erzeugt wurde. Verdampfungsbeschichtungen unterscheiden sich von Beschichtungen, die mit anderen Herstellungsverfahren wie Sputtern erzeugt wurden, beispielsweise durch die Kristallstruktur, die relativ grobkörnig ist. Die Erfinder stellten experimentell fest, dass solche Verdampfungsbeschichtungen insbesondere zur thermischen Isolation in Kraftfahrzeugen geeignet sind.

Die der Erfindung zugrunde liegende Aufgabe wird ferner durch ein Verfahren zur Herstellung einer Niedrigemissionsbeschichtung mit einem Schritt des thermischen Aufdampfens von einer Niedrigemissionsbeschichtung auf einem Substrat gelöst, wobei die Niedrigemissionsbeschichtung im Wesentlichen aus Zinn besteht. Die Beschichtung kann sämtliche, bereits beschriebene Merkmale und/oder Merkmalskombinationen aufweisen. Das Verfahren kann ebenfalls sämtliche entsprechende Merkmale und/oder Merkmalskombinationen des Verfahrens aufweisen.

In einer bevorzugten Ausführungsform des Verfahrens wird ein Beschichtungsmaterial zum Bilden der Niedrigemissionsbeschichtung in einem relevanten flächigen Bereich vollständig durch thermisches Aufdampfen auf dem Substrat aufgebracht. Die vollständige Aufbringung durch thermisches Aufdampfen ist nur dann möglich, wenn das Spritzen des Beschichtungsmaterials verhindert wird. Dies ist, wie die Erfinder feststellten, nur durch spezielle Vorkehrungen möglich. Ansonsten wird ein Teil des Beschichtungsmaterials durch Spritzer auf dem Substrat aufgebracht, was zu Löchern im Substrat führt. Im Zusammenhang mit der vorliegenden Erfindung kann der relevante flächige Bereich ein Bereich der beschichteten Substratbahn sein, der in einem Produkt wie einem Verkleidungsteil verwendet werden soll. Der relevante flächige Bereich kann aus einem Abschnitt einer beschichteten Substratbahn oder eines beschichteten Substrats von mehreren Metern Länge (mindestens 3 m, vorzugsweise mindestens 5 m, noch bevorzugter mindestens 10 m, besonders bevorzugt mindestens 50 m oder 100 m) bestehen, der vorzugsweise über fast die gesamte Breite der Substratbahn abgesehen von jeweils einem schmalen Randbereich an den beiden gegenüberliegenden Rändern der Substratbahn in Längsrichtung mit einer Breite von weniger als 20 cm, vorzugsweise weniger als 10 cm, verläuft. Vorzugsweise besteht der relevante flächige Bereich aus einem Abschnitt einer beschichteten Substratbahn oder eines beschichteten Substrats mit einer Fläche von mindestens 1 m², vorzugsweise mindestens 5 m², noch bevorzugter mindest 10 m², besonders bevorzugt mindestens 50 m² oder 100 m². Vorzugsweise ist der relevante flächige Bereich zusammenhängend und umschließt keine anderen Bereiche auf der beschichteten Substratbahn oder dem beschichteten Substrat, die nicht zu dem relevanten flächigen Bereich gehören. Vorzugsweise hat der relevante flächige Bereich eine Breite von mindestens 50 cm, vorzugsweise mindestens 1 m, besonders bevorzugt mindestens 1,3 m. Bei der Substratbahn oder dem Substrat handelt es sich vorzugsweise um ein flächiges, flexibles Gebilde, insbesondere ein Vlies, ein Gewebe oder eine Folie.

In einer bevorzugten Ausführungsform wird der Schritt des thermischen Aufdampfens in einem Roll Coater durchgeführt. Vorteilhafterweise weist der Roll Coater insbesondere einen hohen Durchsatz auf.

In noch einer bevorzugten Ausführungsform wird das Material der Niedrigemissionsbeschichtung in Form eines Materialdrahts, dessen Querschnittsfläche vorzugsweise zwischen 1,7 und 3,2 mm² beträgt, zu einem Tiegel zugeführt. Dieses Verfahren ist besonders kostengünstig. Durch die relativ geringe Querschnittsfläche des Materialdrahts (Durchmesser von 1,5 bis 2 mm eines runden Drahts) lässt sich ferner die Vorschubgeschwindigkeit des Materialdrahts erhöhen, so dass dieser auf dem Weg zum Tiegel kaum schmilzt.

In einer Weiterbildung der letztgenannten bevorzugten Ausführungsform wird der Materialdraht durch eine Antitropfvorrichtung zugeführt. Die Antitropfvorrichtung umfasst vorzugsweise ein hitzebeständiges, rohrförmiges Element, das aus einem Strahlungsisolationsmaterial besteht, und/oder einen Dämmstoff, der in dem rohrförmigen Element vorgesehen ist und den Beschichtungsmaterialdraht umgibt, und/oder eine Kühleinrichtung, die den Beschichtungsmaterialdraht umgibt. Die Antitropfvorrichtung verhindert, dass der Beschichtungsmaterialdraht vorzeitig schmilzt und aus großem Abstand unkontrolliert auf den Tiegel tropft, wodurch Spritzer verursacht werden.

In noch einer Weiterbildung der letztgenannten bevorzugten Ausführungsform liegt die Vorschubgeschwindigkeit des Materialdrahts zwischen 50 bis 100 cm/min., vorzugsweise zwischen 70 und 80 cm/min..

In noch einer Weiterbildung der letztgenannten bevorzugten Ausführungsform beträgt eine Verdampunfstemperatur des Tiegels zwischen 1900 und 2200 K, vorzugsweise zwischen 1900 bis 2100 K. Diese Verdampfungstemperatur ist für Zinn und Zinnlegierungen mit einem hohen Dampfdruck besonders geeignet.

Die der Erfindung zugrunde liegende Aufgabe wird ferner durch ein Flächenelement mit einer Niedrigemissionsbeschichtung und einem Substrat gelöst, wobei die Niedrigemissionsbeschichtung im Wesentlichen aus Zinn besteht. Das Flächenelement kann ein Abschnitt der beschichteten Substratbahn oder eine gesamte beschichtete Substratbahn direkt nach der Beschichtung sein oder bereits weiter verarbeitet sein. Das Flächenelement kann insbesondere in einem Element zur thermischen Isolation insbesondere für ein Kraftfahrzeug integriert sein. Insbesondere kann das Flächenelement den zuvor erwähnten relevanten flächigen Bereich umfassen. Vorzugsweise umfasst das Flächenelement auf einer (ausgedehnten Seite) des Substrats die Niedrigemissionsbeschichtung und auf einer gegenüberliegenden (ausgedehnten) Seite eine Klebschicht, die vor dem Einsatz mit einer Schutzfolie bedeckt sein kann. Die Beschichtung des Flächenelements kann sämtliche, bereits beschriebene Merkmale und/oder Merkmalskombinationen aufweisen.

In einer bevorzugten Ausführungsform beträgt die maximale Abweichung von einer gewünschten oder mittleren (durchschnittlichen) Schichtdicke in einem relevanten Bereich des Flächenelements <50 %, vorzugsweise <30 %, noch bevorzugter <10 %.

Die der Erfindung zugrunde liegende Aufgabe wird ferner durch ein Verkleidungsteil mit einer Niedrigemissionsbeschichtung, gelöst, wobei die Niedrigemissionsbeschichtung im Wesentlichen aus Zinn besteht. Die Niedrigemissionsbeschichtung ist vorzugsweise Bestandteil eines Flächenelements. Das Verkleidungsteil kann sämtliche im Zusammenhang mit der Beschichtung und dem Flächenelement beschriebenen Merkmale und/oder Merkmalskombinationen aufweisen. Das Verkleidungsteil kann auch zwei räumlich getrennte (beispielsweise durch einen Luftspalt) Niedrigemissionsbeschichtungen umfassen. Das Verkleidungsteil kann Bestandteil der Karosserie eines Kraftfahrzeugs sein oder anderweitig zur Isolation eingesetzt werden. Das Verkleidungsteil kann auch Merkmale und/oder Merkmalskombinationen aufweisen, die in den Patentanmeldungen DE 10 2010 051 612 A1, DE 10 2011 118 420 A1 und DE 10 2013 016 495 A1 und der Gebrauchsmusteranmeldung DE 20 2010 017 432 offenbart sind, soweit dies technisch möglich und sinnvoll ist.

Im Folgenden wird die Erfindung mit Bezugnahme auf die Zeichnung näher beschrieben. Es zeigen:
FIG. 1 eine schematische Ansicht eines Roll Coaters; und
FIG. 2 einen Querschnittsansichtausschnitt eines Verkleidungsteils.

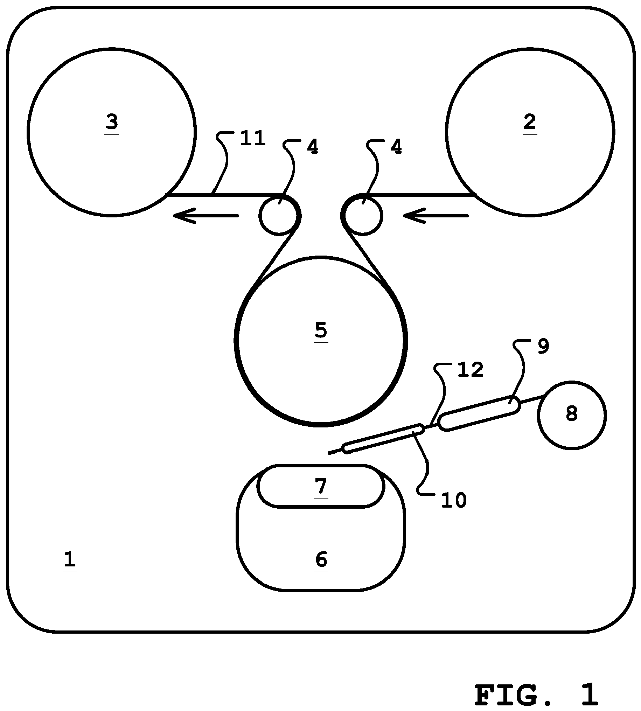

FIG. 1 zeigt eine schematische Ansicht eines Roll Coaters, wie er für die Herstellung der Beschichtungen verwendet werden kann. Auf die Darstellung von Bestandteilen, die im Zusammenhang mit der vorliegenden Erfindung nicht relevant, für den Fachmann aber selbstverständlich sind, wird der Einfachheit halber verzichtet. Der Roll Coater umfasst eine Vakuumkammer 1, in der ein Vakuum vorliegt, einen Abwickler 2, einen Aufwickler 3, eine Transportvorrichtung mit mehreren Rollen 4, eine gekühlte Beschichtungswalze 5, mehrere Verdampfereinheit 6 mit jeweils einem Tiegel 7 (der Einfachheit halber ist lediglich eine der Verdampfereinheiten dargestellt), mehrere Beschichtungsmaterialdrahtrollen 8 (der Einfachheit halber ist lediglich eine der Beschichtungsmaterialdrahtrolle dargestellt), mehrere Beschichtungsmaterialdrahtzuführvorrichtungen 9 (der Einfachheit halber ist lediglich eine der Beschichtungsmaterialdrahtzuführvorrichtungen dargestellt) und mehrere Antitropfvorrichtungen 10 (der Einfachheit halber ist lediglich eine der Antitropfvorrichtungen dargestellt). Je eine Verdampfereinheit 6, eine Beschichtungsmaterialdrahtrolle 8, eine Beschichtungsmaterialdrahtzuführvorrichtung 9 und eine Antitropfvorrichtung 10 wirken wie in der Figur dargestellt zusammen, wobei sie in Reihe unter der Beschichtungswalze 5 nebeneinander angeordnet sind. Eine Substratbahn 11, die von dem Abwickler 2 abgewickelt wird, läuft über die Rollen 4 der Transportvorrichtung und die gekühlte Beschichtungswalze 5 in Pfeilrichtung zu dem Aufwickler 3, der die Substratbahn 11 aufwickelt. Während die Substratbahn 11 über die gekühlte Beschichtungswalze läuft, wird in dem Tiegel 7 der Verdampfereinheit 6 das Beschichtungsmaterial verdampft, das zu der Verdampfereinheit 6 in Form eines Beschichtungsmaterialdrahts 12 von einer Beschichtungsmaterialdrahtrolle 8, über eine Beschichtungsmaterialdrahtzuführvorrichtung 9 und durch eine Antitropfvorrichtung 10 zugeführt wird. Die Verdampunfstemperatur des Tiegels beträgt zwischen 1900 und 2200 K. Der Materialdraht besteht aus einer Zinnlegierung, die ferner Bismut, Silber und/oder Antimon umfasst. Die Vorschubgeschwindigkeit des Materialdrahts liegt im Bereich von 50 bis 100 cm/min. Der Durchmesser des runden Materialdrahts liegt im Bereich von 1,5 bis 2 mm. Die Querschnittsfläche des Materialdrahts beträgt zwischen 1,76 und 3,14 mm². Das verdampfte Beschichtungsmaterial lagert sich auf der Substratbahn 11 ab. Sämtliche Bestandteile des Roll Coaters abgesehen von der Antitropfvorrichtung 10 sind bereits bekannt. Die Antitropfvorrichtung 10 umfasst ein hitzebeständiges, rohrförmiges Element, das aus einem Strahlungsisolationsmaterial besteht, und verhindert, dass der Beschichtungsmaterialdraht 12 vorzeitig schmilzt und aus großem Abstand unkontrolliert auf den Tiegel 7 tropft, wodurch Spritzer verursacht werden. Es kann ferner einen Dämmstoff umfassen, der in dem rohrförmigen Element vorgesehen ist und den Beschichtungsmaterialdraht umgibt, und/oder eine Kühleinrichtung umfassen. Die Antitropfvorrichtung 10 kann in einem Ausgangsstutzen der Beschichtungsmaterialdrahtzuführvorrichtung 9 integriert sein.

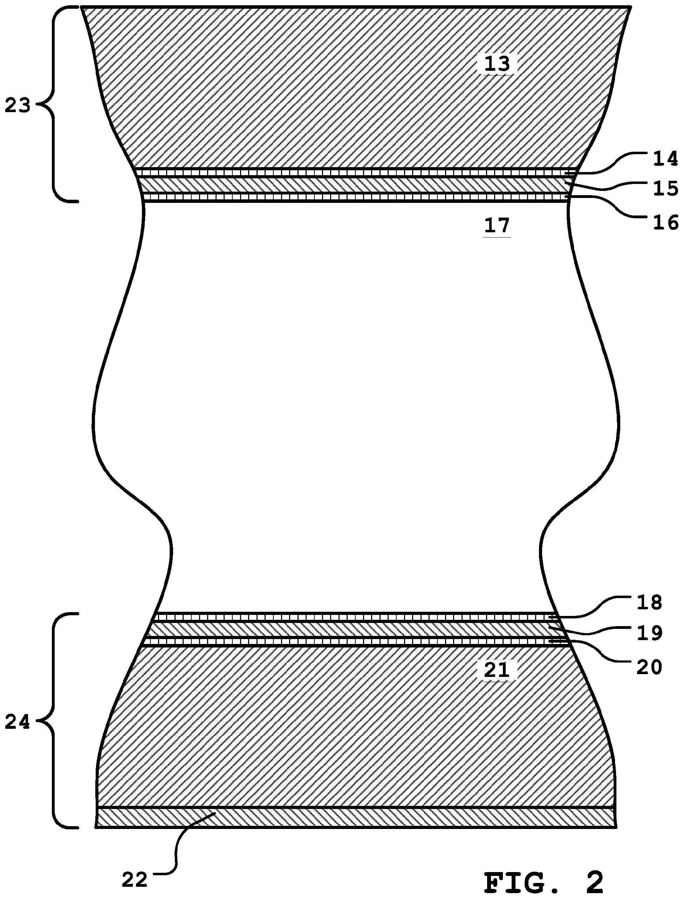

FIG. 2 zeigt einen Querschnittsansichtausschnitt eines Verkleidungsteils. Das Verkleidungsteil umfasst eine Außenwand 23, einen Luftspalt 17 und einen Innenwand 24. Die Außenwand 23 umfasst ein äußeres Verkleidungselement 13, auf dem innen ein Flächenelement vorgesehen ist, das eine Klebschicht 14, ein Substrat 15 und eine Niedrigemissionsbeschichtung 16 umfasst. Das Flächenelement ist mittels der Klebschicht 14 mit dem äußeren Verkleidungselement 13 verbunden. Die Niedrigemissionsbeschichtung 16 ist nach innen ausgerichtet und grenzt an den Luftspalt 17 an. Die Innenwand 24 umfasst ein inneres Verkleidungselement 21, auf dem innen eine Dekorschicht 22 und außen ein Flächenelement vorgesehen ist, das eine Klebschicht 20, ein Substrat 19 und eine Niedrigemissionsbeschichtung 18 umfasst. Das Flächenelement ist mittels der Klebschicht 20 mit dem inneren Verkleidungselement 21 verbunden. Die Niedrigemissionsbeschichtung 18 ist nach außen ausgerichtet und grenzt an dem Luftspalt 17 an.

## Patentansprüche

1. Niedrigemissionsbeschichtung (16, 18), **dadurch gekennzeichnet, dass** die Niedrigemissionsbeschichtung (16, 18) im Wesentlichen aus Zinn besteht.

2. Niedrigemissionsbeschichtung nach Anspruch 1, **dadurch gekennzeichnet, dass** die Niedrigemissionsbeschichtung (16, 18) mindestens 95 % Zinn aufweist.

3. Niedrigemissionsbeschichtung nach Anspruch 1 oder Anspruch 2, **dadurch gekennzeichnet, dass** die Niedrigemissionsbeschichtung (16, 18) aus einer Zinnlegierung besteht, die ferner Bismut, Silber und/oder Antimon umfasst.

4. Niedrigemissionsbeschichtung nach Anspruch 3, **dadurch gekennzeichnet, dass** der Anteil von Bismut, Silber und/oder Antimon zwischen 0,01 und 5 Gew.-%, vorzugsweise zwischen 0,05 und 2 Gew.-%, noch bevorzugter zwischen 0,1 und 1,5 Gew.-%, liegt.

5. Niedrigemissionsbeschichtung nach einem der vorhergehenden Ansprüche, **dadurch gekennzeichnet, dass** die Niedrigemissionsbeschichtung (16, 18) eine Vakuumbeschichtung, vorzugsweise eine Verdampfungsbeschichtung, ist.

6. Verfahren zur Herstellung einer Niedrigemissionsbeschichtung, **gekennzeichnet durch** einen Schritt des thermischen Aufdampfens von einer Niedrigemissionsbeschichtung (16, 18) auf einem Substrat (15, 19), wobei die Niedrigemissionsbeschichtung im Wesentlichen aus Zinn besteht.

7. Verfahren zur Herstellung einer Niedrigemissionsbeschichtung nach Anspruch 6, **dadurch gekennzeichnet, dass** ein Beschichtungsmaterial zum Bilden der Niedrigemissionsbeschichtung (16, 18) in einem relevanten Bereich vollständig durch thermisches Aufdampfen auf dem Substrat (15, 19) aufgebracht wird.

8. Verfahren zur Herstellung einer Niedrigemissionsbeschichtung nach einem der Ansprüche 6 oder 7, **dadurch gekennzeichnet, dass** der Schritt des thermischen Aufdampfens in einem Roll Coater (1) durchgeführt wird.

9. Verfahren zur Herstellung einer Niedrigemissionsbeschichtung nach einem der Ansprüche 6 bis 8, **dadurch gekennzeichnet, dass** das Material der Niedrigemissionsbeschichtung in Form eines Materialdrahts (12), dessen Querschnittsfläche vorzugsweise zwischen 1,7 und 3,2 mm² beträgt, zu einem Tiegel (7) zugeführt wird.

10. Verfahren zur Herstellung einer Niedrigemissionsbeschichtung nach Anspruch 9, **dadurch gekennzeichnet, dass** der Materialdraht (12) durch eine Antitropfvorrichtung (10) zugeführt wird.

11. Verfahren zur Herstellung einer Niedrigemissionsbeschichtung nach einem der Ansprüche 9 bis 10, **dadurch gekennzeichnet, dass** die Vorschubgeschwindigkeit des Materialdrahts zwischen 50 bis 100 cm/min., vorzugsweise zwischen 70 und 80 cm/min., liegt.

12. Verfahren zur Herstellung einer Niedrigemissionsbeschichtung nach einem der Ansprüche 9 bis 11, **dadurch gekennzeichnet, dass** eine Verdampunfstemperatur des Tiegels zwischen 1900 und 2200 K, vorzugsweise zwischen 1900 bis 2100 K, beträgt.

13. Flächenelement mit einer Niedrigemissionsbeschichtung (16, 18) und einem Substrat (15, 19), **dadurch gekennzeichnet, dass** die Niedrigemissionsbeschichtung (16, 18) im Wesentlichen aus Zinn besteht.

14. Flächenelement nach Anspruch 9, **dadurch gekennzeichnet, dass** die maximale Abweichung von einer gewünschten oder mittleren (durchschnittlichen) Schichtdicke in einem relevanten flächigen Bereich des Flächenelements <50 %, vorzugsweise <30 %, noch bevorzugter <10 % beträgt.

15. Verkleidungsteil mit einer Niedrigemissionsbeschichtung **dadurch gekennzeichnet, dass** die Niedrigemissionsbeschichtung (16, 18) im Wesentlichen aus Zinn besteht.
